# EUROPEAN PATENT APPLICATION

(11) **EP 1 827 062 A2**
(43) Date of publication of application: **29.08.2007**
(21) Application number: 07002932.7
(22) Date of filing: 12.02.2007
(51) Int. Cl.: H05K 1/11, H05K 3/34

(54) **Electronic device**

(30) Priority: 27.02.2006 JP 2006051181
(71) Applicant: DENSO CORPORATION, Kariya-city, Aichi-pref. 448-8661 (JP)
(72) Inventor: Ito, Atsushi, Kariya-city, Aichi-pref. 448-8661 (JP); Honda, Takayoshi, Kariya-city, Aichi-pref. 448-8661 (JP)
(74) Representative: Winter, Brandl, Fürniss, Hübner Röss, Kaiser, Polte Partnerschaft Patent- und Rechtsanwaltskanzlei

(57) **Abstract**

In an electronic device , a QFN is surface-mounted on a printed board . The QFN includes a main body containing an IC chip , a reinforcement portion , and multiple terminal portions . The reinforcement portion is exposed from a bottom portion of the main body and mechanically coupled with multiple reinforcement lands on the printed board. The multiple terminal portions are exposed from a peripheral of the main body and electrically coupled with multiple lands on the printed board. In the printed board, the multiple lands are connected with multiple conductive wires Some of the multiple conductive wires are outside of the surface-mounted area . The others are inside of the surface-mounted area to face the reinforcement lands. This enhances a mounting efficiency in the printed board.

## Description

### FIELD OF THE INVENTION

The present invention relates to an electronic device.

### BACKGROUND OF THE INVENTION

Patent document 1 discloses an electronic device, in which an electronic component is surface-mounted on a printed board.

Between the mounted electronic component and the printed board, a solder is provided. Providing the solder increases heat dissipation and connection strength between the electronic component and printed board.
- Patent document 1: JP- 2002-299529 A (US6728106 B2)

In contrast, thus providing the solder prevents arrangement of wiring between the electronic component and printed board. This results in decrease in a density in mounting or packaging.

### SUMMARY OF THE INVENTION

It is an object of the present invention to an electronic device, which enhances a mounting efficiency in a printed board.

According to an aspect of the present invention, an electronic device is provided as follows. An electronic component and a printed board are included. The electronic component includes (i) a main body, (ii) an IC chip contained in the main body, and (iii) a plurality of terminal portions exposed from the main body. The main body of the electronic component is mounted to the printed board. The printed board includes (i) a plurality of lands electrically coupled with the terminal portions of the electronic component, (ii) a plurality of conductive wires electrically coupled with the lands, and (iii) a connection member, which mechanically connects the printed board with a surface of the main body, the surface facing the printed board, to thereby mount the electronic component to the printed board. The conductive wires include a first conductive wire, which is arranged within a surface area of the printed board, the surface area facing the main body of the electronic component. The connection member is configured to have a shape to correspond to the first conductive wire arranged within the facing area of the printed board.

Under this structure, at least a portion of the multiple conductive wires is inside of the facing area as a surface-mounted area in the printed board, where the electronic component is surface-mounted. This increase an area or space surrounding the electronic component and the surface mounted area to thereby enhance an efficiency in mounting or packaging.

### BRIEF DESCRIPTION OF THE DRAWINGS

The above and other objects, features, and advantages of the present invention will become more apparent from the following detailed description made with reference to the accompanying drawings. In the drawings:
FIG. 1 is an exploded view illustrating an overall structure of an electronic device according to a first embodiment of the present invention;
FIG. 2 is a view illustrating a cross-sectional structure of a QFN in the electronic device of the first embodiment;
FIG. 3A is a view illustrating a printed board of the first embodiment;
FIG. 3B is a cross-sectional view of the electronic device of the first embodiment;
FIG. 4 is a view illustrating a printed board of an electronic device as a modification 1;
FIG. 5 is a view illustrating a printed board of an electronic device as a modification 2;
FIG. 6 is a view illustrating a printed board of an electronic device as a modification 3;
FIG. 7 is a view illustrating a printed board of an electronic device as a modification 4;
FIG. 8 is a view illustrating a printed board of an electronic device as a modification 5;
FIG. 9A is a view illustrating a printed board of an electronic device as a modification 5;
FIG. 9B illustrates an enlarged view of wires;
FIG. 10A is a view illustrating a printed board of a comparative example; and
FIG. 10B illustrates an enlarged view of wires.

### DETAILED DESCRIPTION OF THE PREFERRED EMBODIMENTS

### (First Embodiment)

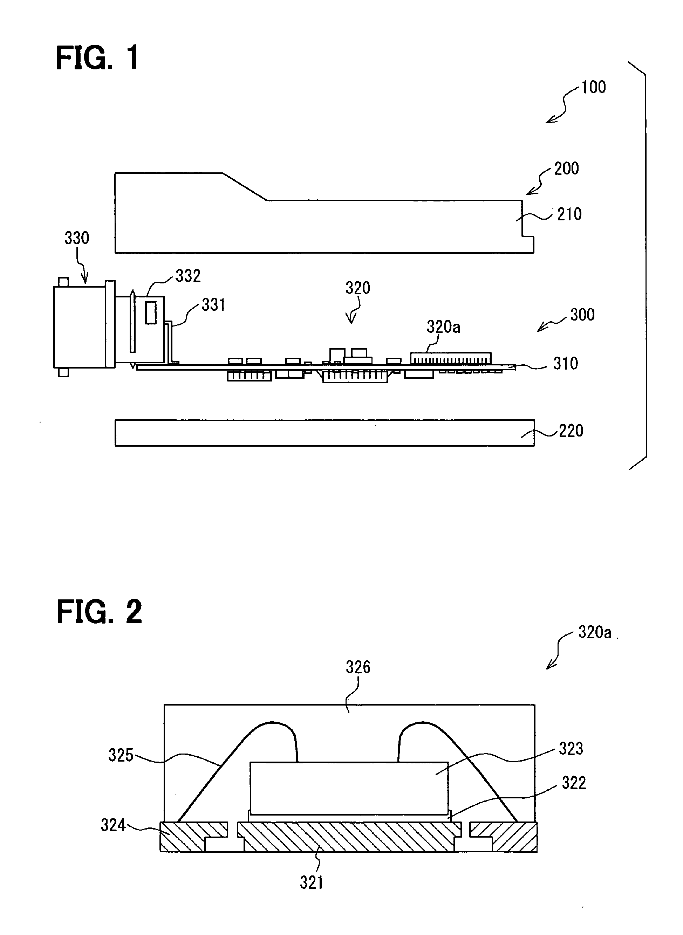

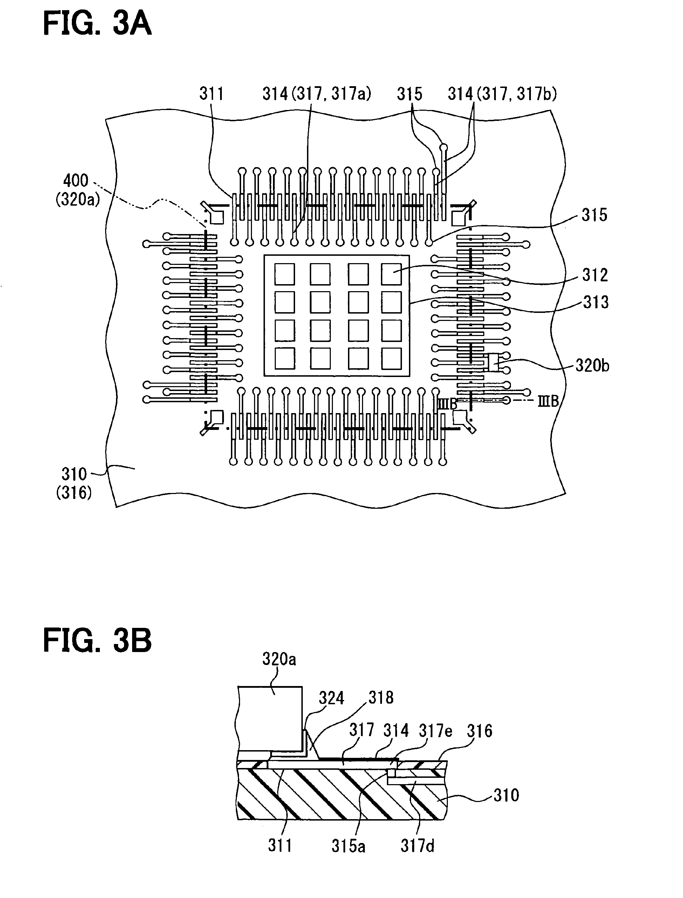

An overall structure of an electronic device 100 according to a first embodiment of the present invention is illustrated in FIG. 1, as an exploded view before assembling or packaging. FIG. 2 illustrates a cross-sectional structure of an electronic component included in the electronic device 100. FIG. 3A illustrates, of a printed board, vicinities of a surface-mounted area, where the electronic component is mounted. FIG. 3B illustrates a cross-sectional view of the electronic device in a vicinity of the surface-mounted area. The electronic device is suitable, for instance, for an electronic control unit constituting a vehicular engine ECU (Electronic Control Unit).

As shown in FIG. 1, the electronic device 100 includes a housing 200 and a circuit board 300.

The housing 200 is made of metal material (i.e., aluminum, iron) or synthetic resin material. The housing 200 includes (i) a case 210 shaped of a container with an opening and (ii) an approximately rectangular shallow-depth cover 220 sealing the opening of the case 210. The case 210 and cover 220 are packaged or assembled with each other to form the housing 200 while the circuit board 300 is contained in an internal space of the housing 200. In this embodiment, the case 210 and cover 220 are fixedly screwed to each other. The housing 200 is not limited to the above structure, but may be constructed of one integrated member or three members.

The circuit board 300 includes (i) a printed board 310, and (ii) components surface-mounted on the printed board 310. The printed board 310 includes lands 311, reinforcement lands 312, conductive wires 317 (i.e., electric wiring lines), inner layer wires 317d, via-holes 315a coupling wires (e.g., coupling a wire 317 with an inner layer wire 317d), and the like. The mounted components include (i) electronic components 320 such as a microcomputer, a power transistor, a resistance, and a capacitor, and (ii) a connector 330 as an external connection terminal (i.e., an input/output unit). Material of the printed board 310 may be thermo-plastic resin, thermoset resin, ceramic, or a complex of glass (e.g., glass cloth) and resin, all of which are known. On a surface of the printed board 310, a resist 316 is formed.

The connector 330 includes (i) terminals 331 made of conductive material and (ii) a connector housing 332 containing the terminals 331. Of each of the terminals 331, one end is mounted on the printed board 310, while the other end is exposed from the housing 200. The housing 200 has a cut portion (not shown). Through the cut portion, a portion of the connector 330 enters an inside of the housing 200. The case 210 and cover 220 are fixedly screwed to each other to contain the circuit board 300. The other remaining portion of the connector 330 is exposed from the housing 200.

Multiple terminals 331 are punched terminals, which are formed by punching a metal plate, and partially embedded within the connector housing 332 such that individual terminals do not interfere with each other. A board-side terminal end of the terminal 331, which is mounted on the printed board 310, protrudes from a peripheral side of the connector housing 332 in approximately parallel with the printed board 310 and then bends downwards (to approach the printed board 310). Further, a tip of the bent portion of the board-side terminal end is bent parallel with the printed board 310 to be configured as a connection portion to a land provided on the printed board 310. In this embodiment, one connector housing 332 has multiple terminals 331 arranged in a row. The connection portions of the terminals 331 are arranged in a row with respect to the printed board 310. However, the terminals 331 may be differently arranged without limited to the above structure.

For instance, one electronic component 320 is a QFN (Quad Flat Non-Leaded Package) 320a of a surface-mounted type shown in FIG. 2. The QFN 320a shaped of a rectangular parallelepiped, includes a reinforcement portion 321, an adhesive 322, an IC chip 323, multiple terminal portions 324, multiple leads 325, and a main body 326. The IC chip 323 is connected to the reinforcement portion 321 via the adhesive 322. An electrode (not shown) of the IC chip 323 is electrically coupled with the terminal portion 324 by the lead 325. The main body 326 of the QFN 320a is formed by resin-molding the IC chip 323, the adhesive 322, part of the reinforcement portion 321, part of the terminal portions 324, and the leads 325. The other part of the reinforcement portion 321 and the other part of the terminal portions 324 are exposed from the main body 326. The reinforcement portion 321 is used for supporting connection with the printed board 310 and dissipating heat due to operation of the QFN 320a or IC chip 323 towards the printed board 310.

Next, explanation will be made with respect to wires 317 in a mounted area 400 where the QFN 320 is surface-mounted in the printed board 310.

The mounted area 400, which is approximately rectangular, is illustrated in FIG. 3A to be surrounded by a chain double-dashed line. In this mounted area 400 and its surrounding area, the printed board 310 includes multiple lands 311, multiple wires 317, and reinforcement lands 312. The lands 311 are made of conductive members such as copper foil and arranged to adjoin to each other with intervals while individually corresponding to terminal portions 324 exposed from the main body 326 of the QFN 320a. For instance, the lands are arranged to cross peripheral lines of the mounted area 400, as shown in FIG. 3A.

One wire 317 corresponds to and is electrically connected with one land 311 as shown in FIG. 3B. The wire 317 has a via-hole connection portion 317e, which is electrically coupled with an inner layer wire 317d via a via-hole 315a. The via-hole 315a is a hole, which is formed in the printed board 310 with a laser or the like and filled with conductive pastes.

The width of the via-hole connection portion 317e is larger than that of the wire 317 to secure connection reliability. When the shape of the via-hole connection portion 317e is circle to meet the shape of the via-hole 315a, the diameter of the via-hole connection portion 317e is larger than the width of the wire 317.

The wire 317 is provided with a resist 314 thereon to prevent unintentional electrical connection with an adjacent wire 317. A via-hole portion 315 is defined as a combination of the via-hole connection portion 317e, the via-hole 315a, and a resist, which is provided to the via-hole connection portion 317e. The via-hole portion 315 has a shape meeting the diameter of the via-hole connection portion 317e.

As long as a wire 317 is electrically coupled with a corresponding land 311, the wire 317 may be integrated with the land 311 or separated from the land 311.

The reinforcement lands 312 and the solder resist 313 function as a connection member, which is coupled with the reinforcement portion 321 of the QFN 320a with solder 318. The reinforcement land 312 is used for supporting connection with the QFN 320a and dissipating heat due to operation of the QFN 320a or IC chip 323 towards the printed board 310. The reinforcement land 312 is made of conductive material such as copper foil similarly with the land 311. A solder resist 313 is provided to surround the reinforcement land 312 and electrically isolate the reinforcement land 312 from an outside thereof. When the reinforcement land 312 is electrically coupled with the ground potential, radiating noises from the IC chip 323 may be suitably decreased.

As explained above, the printed board 310 includes the multiple lands 311, the multiple reinforcement lands 312, and the multiple wires 317. The QFN 320a includes the multiple terminal portions 324 and the reinforcement portion 321. The multiple terminal portions 324 of the QFN 320a are electrically coupled with the lands 311 of the printed board 310 and the reinforcement portion 321 of the QFN 320a is surface-mounted to be mechanically coupled with the reinforcement lands in the printed board 310 with solder 318.

The multiple wire 317 include at least first inside wires 317a, which are arranged within the mounted area 400 surrounded by a chain double-dashed line in FIG. 3A. In other words, the mounted area 400 is an area where the printed board 310 faces the QFN 320a.

For instance, an inside wire 317a is defined as a wire arranged inside of the mounted area 400 and an outside wire 317b is defined as a wire arranged outside of the mounted area 400. Here, the inside wires 317a and the outside wires 317b are alternately arranged along a peripheral line or side of the mounted area 400, as shown in FIG. 3A. Alternate arrangement of the inside and outside wires 317a, 317b allows a relatively large interval between adjacent wires 317. Between the adjacent outside wires 317b, a bypass capacitor 320b for decreasing noises is electrically mounted. In other words, the bypass capacitor 320b is electrically mounted to bridge the adjacent outside wires 317b.

The reinforcement lands 312 and the solder resist 313 as the connection member are arranged within the mounted area 400 to receive the inside wires 317a. In other words, within the mounted area 400, both the connection member 312, 313 and the inside wires 317a co-exist without interfering each other. In this embodiment, the reinforcement lands 312 and the solder resist 313 are arranged to face the inside wires 317a with a predetermined interval.

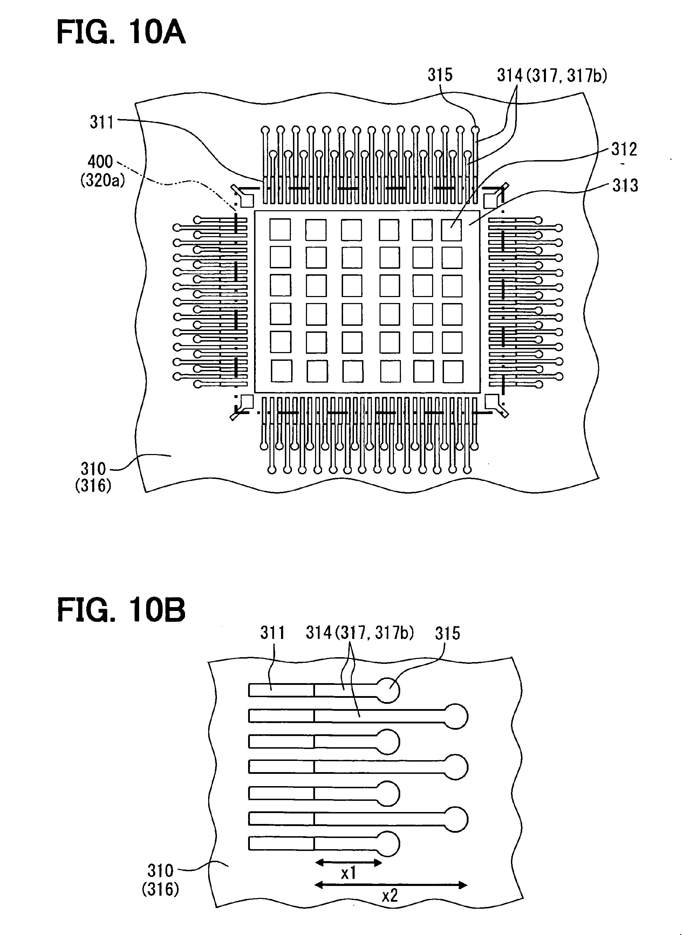

Next, the electronic device 100 of this embodiment is compared to an electronic device as a comparative example having a QFN in FIGS. 10A, 10B. FIG. 10A illustrates a printed board 310 of the comparative example. FIG. 10B illustrates an enlarged view of the wires 317.

In FIG. 10A, reinforcement lands 312 and a solder resist 313 are arranged in an approximately entire mounted area 400. Thus, wires 317 are arranged outside of the mounted area 400. A via-hole portion 315 is defined as a combination of a via-hole connection portion 317e, a via-hole 315a, and a resist, which is provided to the via-hole connection portion 317e.

The adjacent via-hole portions 315 need to be separated from each other. The via-hole portion 315 and the wire 317 also need to be separated from each other. To that end, as shown in FIG. 10B, individual via-holes 315a are arranged in a zigzag pattern or staggered pattern, and wires 317 need to have two different lengths (x1, x2) to correspond to the via-holes arranged in the zigzag pattern. In other words, in the comparative example, wires 317 include two types of wires with a length of x1 from a land 311 and wires with a length of x2 from a land 311.

In contrast, in this embodiment, wires 317 are arranged both inside of the mounted area 400 and outside of the mounted area 400. Thus, an interval between adjacent wires can be provided to be relatively larger. As a result, lengths of the wires can be an identical length, e.g., x1 from a land 311. In other words, in comparison with the comparative example in FIGS. 10A, 10B, the electronic device 100 of this embodiment can provide, outside the mounted area 400, an additional mounted area corresponding to the inside wires 317a arranged inside of the mounted area 400 and the differences of (x2 - x1).

Thus, at least part (i.e., inside wire 317a) of wires 317 are arranged within the mounted area 400. The reinforce lands 312 and the solder resist 313 are designed to be arranged such that the inside wires 317a are also accommodated within the mounted area 400. This layout of the printed board 310 secures an additional area surrounding the mounted area 400 (or the mounted QFN 320a) for another component to be mounted. This enhances a mounting efficiency in the printed board 310. An electronic device such as an engine ECU has been recently required to be multi-functional and small-sized. The electronic device 100 of this embodiment capable of enhancing the mounting efficiency in the printed board 310 is suitably applied to an engine ECU.

Securing an area surrounding the QFN 320a allows a noise-decrease elemental component such as a bypass capacitor 320b to be mounted in proximity of the electronic component (i.e., QFN 320a). This decreases conductive noises.

In the above embodiment, a QFN 320a is applied as an electronic component; however, another component can be also applied. Requirements for this component are as follows: (i) terminal portions exposed from a main body of the electronic component are electrically coupled with lands in a printed board, and (ii) the main body is mechanically coupled with a surface of the main body, which the printed board faces, (i.e., the main body is mechanically coupled with at least a part of a mounted area in a printed board).

### (Modification 1)

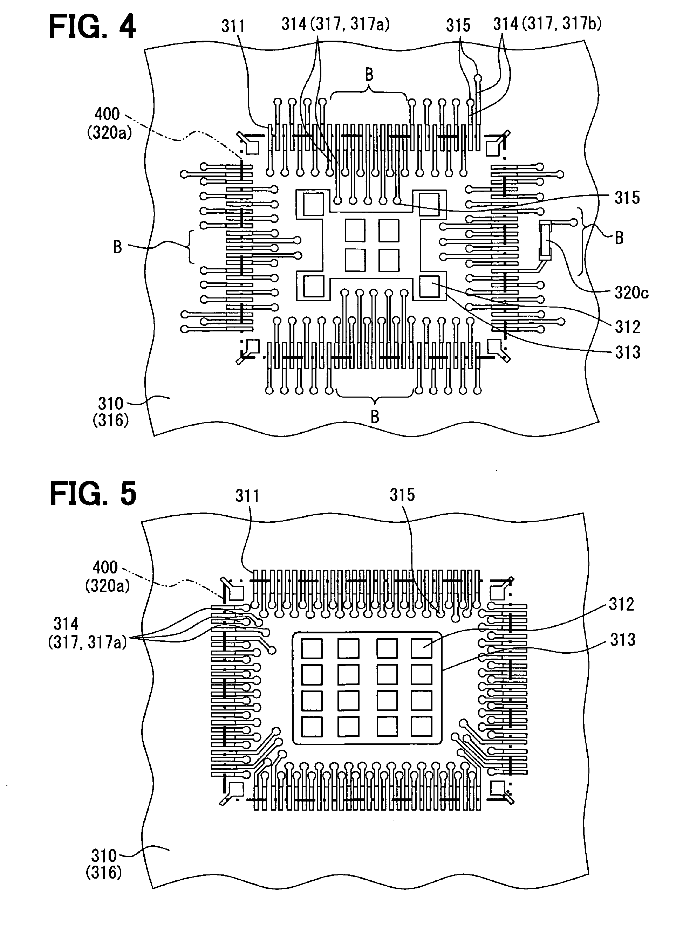

FIG. 4 illustrates a printed board 310 of an electronic device as a modification 1.

A modified part is mainly explained below. The different features are layouts of inside wires 317a, reinforcement lands 312, and solder resist 313.

Adjacent lands can be sequentially coupled only with inside wires 317a without being coupled with outside wires 317b. With reference to Area B in FIG. 4, adjacent multiple lands 311 are connected only with inside wires 317a instead of being connected with outside wires.

In this case, the area of the connection member (i.e., the reinforcement lands 312 and solder resist 313) is decreased compared with that in the first embodiment. To that end, the connection member further includes four protruding portions partially protruding towards an area, where few inside wires 317a are arranged, so as to secure strength of connection between the QFN 320a and the printed board 310.

Thus, arranging multiple inside wires 317 serially coupled with adjacent lands 311 within the mounted area 400 allows a relatively large area to be secured in a peripheral area surrounding the QFN 320a. As a result, a relatively large-sized elemental component 320c can be arranged in proximity of the QFN 320a. This enhances a mounting efficiency in the printed board 310.

### (Modification 2)

FIG. 5 illustrates a printed board 310 of an electronic device as a modification 2.

A modified part is mainly explained below. The different features are layouts of inside wires 317a.

As shown in FIG. 5, all wires 317 can be provided as inside wires 317a, which are arranged within the mounted area 400, where the main body 326 is mounted. Thus, arranging all the wires 317 as inside wires 317a within the mounted area 400 allows a relatively large area to be secured in a peripheral area surrounding the QFN 320a. As a result, this enhances a mounting efficiency in the printed board 310.

### (Modification 3)

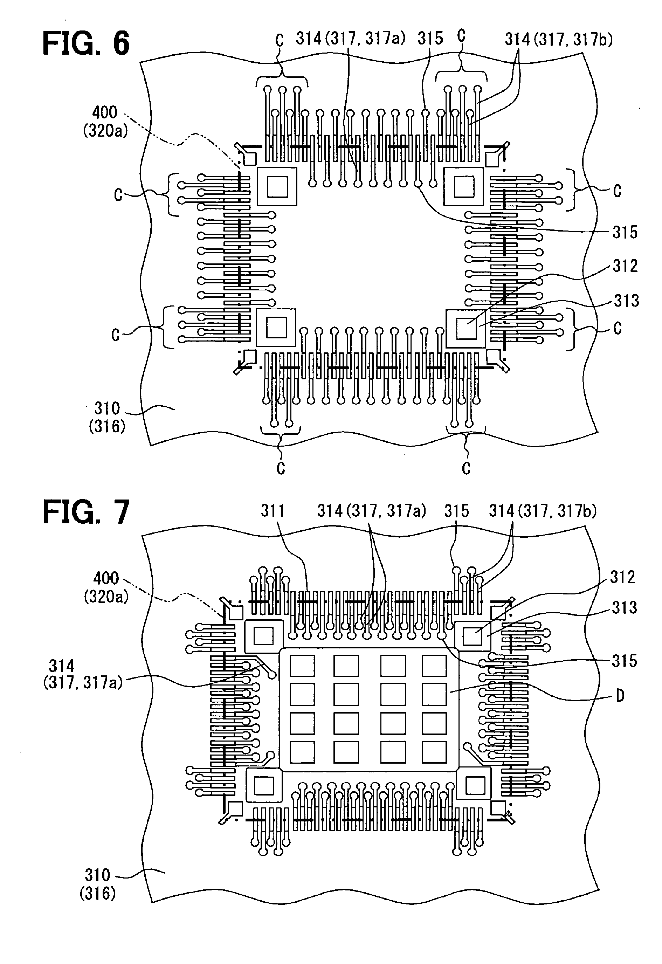

FIG. 6 illustrate a printed board 310 of an electronic device as a modification 3.

A modified part is mainly explained below. The different features are layouts of reinforcement lands 312 and solder resist 313.

As shown in FIG. 6, the connection member (i.e., reinforcement lands 312 and solder resists 313) may be provided as four corner connection sub-members, which are arranged closely to four corners of the approximately rectangular mounted area 400. Further, wires 317 corresponding to lands arranged around the four corners of the mounted area 400 are arranged as corner outside wires 317b, which are shown in Area C in FIG. 6. In other words, each pair of a reinforcement land 312 and solder resist 313, as one corner connection sub-member, is located closely to lands around one corner of the mounted area 400 without any inside wire intervening; further, the lands around the one corner are coupled with the corner outside wires 317b outside of the mounted area 400.

In the reinforcement portion 321 of the QFN 320a, a stress is apt to be applied to four corners. Therefore, arranging the reinforcement lands 312 and solder resists 313 to correspond to the four corners of the reinforcement portion 321 secures a strength in connection with the QFN 320a. Further, arranging wires 317 corresponding to lands around the four corners of the mounted area 400 as the corner outside wires 317b allows arrangement of the reinforcement lands 312 and solder resists 313 to correspond to the four corners of the reinforcement portion 321.

### (Modification 4)

FIG. 7 illustrates a printed board 310 of an electronic device as a modification 4.

A modified part is mainly explained below. The different features are layouts of wires 317, reinforcement lands 312, and solder resist 313.

The connection member (i.e., reinforcement lands 312 and solder resists 313) further includes a central connection sub-member, which is arranged in a central area (i.e., Area D in FIG. 7) within the mounted area 400, in addition to the four corner connection sub-members, which correspond to the four corners of the reinforcement portion 321. Here, similarly to the modification 3, of all the wires, wires corresponding to lands arranged around four corners of the mounted area 400 are provided as the corner outside wires 317b; namely, no inside wires is provided in an area corresponding to the four corners of the reinforcement portion 321 of the QFN 320a.. In contrast, the other wires are provided as inside wires 317a.

Further, the reinforcement lands 312 of the central connection sub-member arranged in Area D may be electrically coupled with the ground. This structure helps decrease radiation noises of the IC chip 323 and exogenous noises.

### (Modification 5)

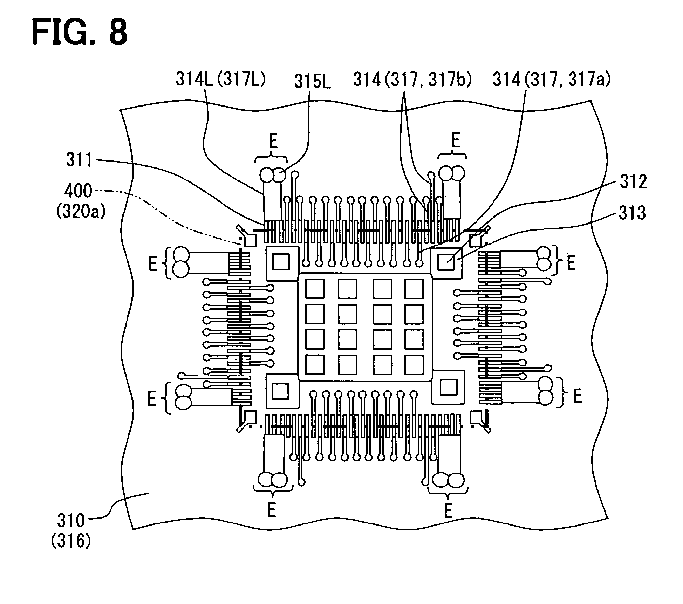

FIG. 8 illustrates a printed board 310 of an electronic device as a modification 5.

A modified part is mainly explained below. The different features are layouts of wires 317.

As shown in Area E in FIG. 8, each of eight wider large-current wire 317L is arranged to connected to at least two lands 311 around a corner of the mounted area 400 for large current to flow. In FIG. 8, a corresponding resist 314L and a via-hole portion 315L are also illustrated.

The large-current wire 317L needs many via-holes, which are not easily arranged within the mounted area 400. When reinforcement lands 312 and solder resists 313 are arranged to correspond to the four corners of the reinforcement portion 321, lands around the corners of the mounted area 400 are required to be connected with the corner outside wires 317b. Therefore, the corner outside wires 317b coupled with the lands 311 around the corners are suitably used for a large-current wire.

### (Modification 6)

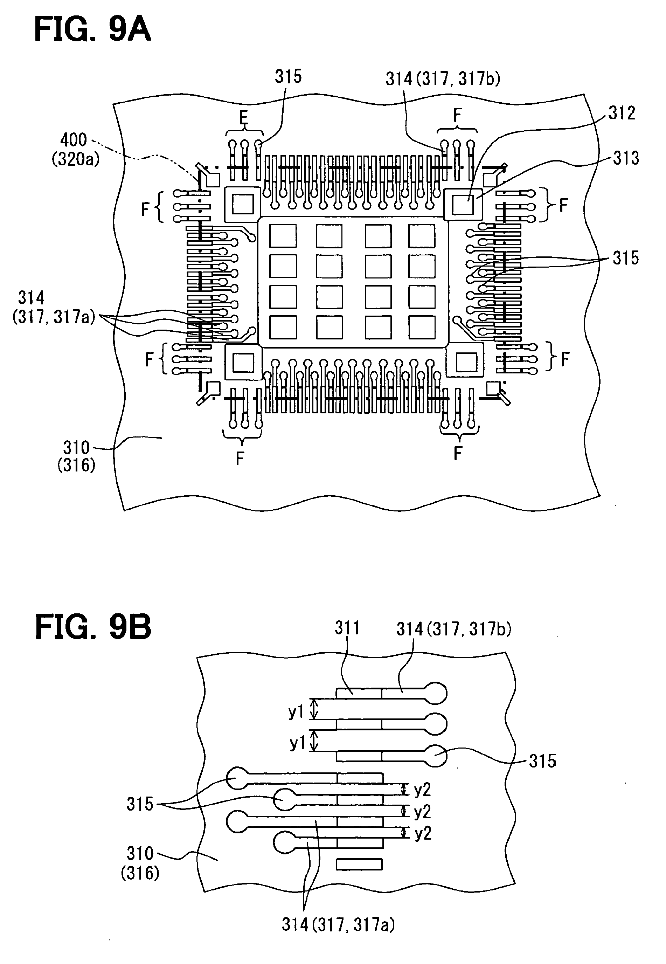

FIG. 9A illustrates a printed board 310 of an electronic device as a modification 6. FIG. 9B illustrates an enlarged view of wires 317.

A modified part is mainly explained below. The different feature is an interval between wires.

As shown in Area F in FIG. 9A, of all wires 317, wires corresponding to lands arranged around the four corners of the mounted area 400 are arranged as corner outside wires 317b; the other wires are provided as inside wires 317a. In this case, an interval y1 between the corner outside wires 317b (in Area F) is designed to be larger than an interval y2 between the inside wires 317a. In this case, lands 311 are alternately coupled with wires, i.e., wires 317b are coupled with every other land 311. Therefore, a land 311 not coupled with a wire is present.

Designing an interval y1 between the corner outside wires 317b (in Area F) as being larger than an interval y2 between the inside wires 317a eliminates necessity of designing two different lengths of wires to correspond to via-holes 315a in a zigzag pattern in FIG. 10B or Area C in FIG 6.

It will be obvious to those skilled in the art that various changes may be made in the above-described embodiments of the present invention. However, the scope of the present invention should be determined by the following claims.

## Claims

1. An electronic device (100) comprising:
an electronic component (320a) including
a main body (326),
an IC chip (323) contained in the main body, and
a plurality of terminal portions (324) exposed from the main body; and
a printed board (310), to which the main body of the electronic component is mounted, the printed board including
a plurality of lands (311) electrically coupled with the terminal portions of the electronic component,
a plurality of conductive wires (317) electrically coupled with the lands, and
a connection member (312, 313), which mechanically connects the printed board with a surface of the main body, the surface facing the printed board, to thereby mount the electronic component to the printed board,
wherein the conductive wires include a first conductive wire (317a), which is arranged within a surface area (400) of the printed board, the surface area facing the main body of the electronic component, and
wherein the connection member is configured to have a shape to correspond to the first conductive wire arranged within the facing area of the printed board.

2. The electronic device of claim 1,
wherein the conductive wires include a plurality of first conductive wires (317a), which are arranged inside of the facing area, and a plurality of second conductive wires (317b), which are arranged outside of the facing area.

3. The electronic device of claim 2,
wherein the first conductive wires and the second conductive wires are alternately arranged along a peripheral line of the facing area.

4. The electronic device of claim 2, wherein
an elemental component (320b) for decreasing noises is electrically mounted to bridge the adjacent second conductive wires.

5. The electronic device of claim 2, wherein
the electronic component includes a reinforcement portion (321), which supports the IC chip and is exposed from the main body and mechanically connected with the connection member in the printed board.

6. The electronic device of claim 5, wherein
the connection member includes four corner connection sub-members, which are arranged to individually face four corners of the reinforcement portion of the electronic component,
the second conductive wires include corner outside conductive wires, which are arranged to oppose each corner connection sub-member via a peripheral line of the facing area with no first conductive wires intervening.

7. The electronic device of claim 6, wherein
an interval between adjacent two wires of the corner outside conductive wires is larger than an interval between two adjacent conductive wires other than the corner outside conductive wires.

8. The electronic device of claim 6, wherein
one (317L) of the corner outside conductive wires is electrically coupled with at least two lands for large current to flow.

9. The electronic device of any one of claims 6 to 8, wherein
the connection member further includes a central connection sub-member arranged in a central portion (D) of the facing area, and
first conductive wires are arranged in the facing area to intervene between the central connection sub-member and a peripheral line of the facing area.

10. The electronic device of claim 9, wherein
the central connection sub-member is electrically coupled with a ground.

11. The electronic device of claim 1, wherein
all of the conductive wires are first conductive wires, which are arranged within the facing area.

12. The electronic device of any one of claims 1 to 11, wherein
the conductive wires include a plurality of first conductive wires (317a), which are arranged in the facing area to adjoin each other.

13. The electronic device of any one of claims 1 to 12, wherein
wherein the connection member includes a reinforcement land (312) and a solder resist (313).

14. The electronic device of any one of claims 1 to 13, wherein
the facing area is approximately rectangular.

15. The electronic device of claim 14, wherein
each of the lands is arranged to cross a peripheral line of the facing area.
